# EUROPEAN PATENT SPECIFICATION

(11) **EP 1 777 500 B1**
(45) Date of publication and mention of the grant of the patent: **05.09.2012**
(21) Application number: 06021431.9
(22) Date of filing: 12.10.2006
(51) Int. Cl.: G01C 21/36

(54) **Vehicle-mounted electronic apparatus**
Im Fahrzeug angebrachtes elektronisches Gerät
Appareil électronique embarqué à bord d'un véhicule

(30) Priority: 19.10.2005 JP 2005305102
(43) Date of publication of application: 25.04.2007
(73) Proprietor: FUJITSU TEN LIMITED, Kobe-shi, Hyogo (JP)
(72) Inventor: Matsuo, Kensuke, Hyogo-ku, Kobe-shi Hyogo (JP)
(74) Representative: Beetz & Partner

(56) References cited:
- EP-A1- 0 734 007
- EP-A1- 0 868 116
- EP-A1- 1 338 865
- DE-A1- 10 037 596
- JP-A- 10 276 249
- JP-A- 2001 246 974
- JP-A- 2003 203 469
- JP-A- 2004 314 777
- JP-A- 2005 001 400
- JP-A- 2005 216 390
- US-A- 5 207 471
- US-A- 5 796 579
- US-A- 5 808 860
- US-A- 6 101 088
- US-A1- 2003 202 330
- US-A1- 2005 155 068
- US-B1- 6 310 747

## Description

### BACKGROUND OF THE INVENTION

### 1. FIELD OF THE INVENTION

The present invention relates to a vehicle-mounted electronic apparatus, and more particularly to a technique that is suitable for use in a vehicle-mounted apparatus such as an audio visual navigation system.

### 2. DESCRIPTION OF THE RELATED ART

Vehicle-mounted apparatuses such as navigation systems have been developed for commercial use (refer to Japanese Unexamined Patent Publication JP-A 2002-318129, for instance). Such vehicle-mounted apparatuses are generally designed in conformity with the DIN (Deutsche Industre Normen) standards. In terms of general versatility, limitations of mounting space, or other factors, there may be cases where a vehicle-mounted apparatus of 1 DIN size (a model of the type that is designed to fit in a 1-DIN space) is preferable to a vehicle-mounted apparatus of 2 DIN size (a model of the type that is designed to fit in a 2-DIN space).

In particular, it is very difficult due to a restriction on size to store a display, a disk player, a hard disk drive and a navigation function in a space of 1 DIN standard size. Just arrangement of a plurality of components and boards for controlling the components is difficult. Besides, many of the components mounted on the boards become hot or generate noise. Consequently, the space is further restricted, which hinders downsizing. Moreover, packing a number of components into a main body has a problem such that maintenanceability gets worse because, for example, the boards hide the components.

US 2005/0155068 discloses a multi media player having a DVD player and a digital media reader (card reader).

JP 2005/216390 discloses a disk device having a display provided in front of a DVD and a HDD.

### SUMMARY OF THE INVENTION

It is the object of the invention to provide a versatile vehicle-mounted apparatus.

This object is accomplished by the features of claim 1.

A vehicle-mounted electronic apparatus comprises:
a display section for displaying information thereon;
a reproducing section for reproducing information recorded in a recording medium to be inserted;
a HDD containing information recorded therein; and
a main body unit for housing the display section, the reproducing section, and the storage medium which are stacked in this order, the main body unit having an opening portion through which the storage medium can be attached to and detached from the main body unit.

According to the invention, the main body unit houses the display section, reproducing portion, and the storage medium which are stacked in this order, so that the apparatus can be made thin.
The main body unit may have a height in dimension in conformity with a 1 DIN standard.
housed in the main body unit.

The display section, the reproducing section, and the storage medium can be stacked one after another and then housed in the main body unit in conformity with the 1 DIN standard, so that the apparatus can be made thin.

It is preferable that the vehicle-mounted electronic apparatus further comprises:
a first board in which an avoiding portion for avoiding interference with the storage medium is formed;
a second board arranged on the storage medium; and
a connecting section that connects the storage medium with the second board.

According to the invention, it becomes possible to arrange the first board and the storage medium in a row, with the result that it is possible to make the electronic apparatus thin in a thickness direction, and it is also possible to shorten a distance between the storage medium and the second board. Therefore, a communication speed does not become slow, and an influence of noise or the like is little, with the result that it is possible to secure good quality of service.

It is further preferable that the reproducing section and the second board are arranged so that the reproducing section and at least a part of the second board overlap with each other, and
a height of a component arranged on the second board in an area overlapping the reproducing section is lower than a height of a component arranged on the second board in an area not overlapping the reproducing section.

According to the invention, the height of the component arranged on the second board in an area overlapping the reproducing section is lower than the height of the component arranged on the second board in an area not overlapping the reproducing section, and it is therefore possible to efficiently arrange the mounted components in a vacant space, downsize in the thickness direction, and provide the vehicle-mounted electronic apparatus with a number of functions.

An apparatus of related art comprises
a storage medium;
a first board in which an avoiding portion shaped into a cutout or a hole for avoiding interference with the storage medium is formed;
a second board arranged over or under the storage medium; and
a connecting section that connects the storage medium arranged in the avoiding portion of the first board with the second board.

According to the invention, it becomes possible to arrange the first board and the storage medium (for example, a hard disk drive) in a row, with the result that it is possible to make the electronic apparatus thin in a thickness direction, and it is also possible to shorten a distance between the storage medium (for example, a hard disk drive) and the second board. Therefore, a communication speed does not become slow, and an influence of noise or the like is little, with the result that it is possible to secure good quality of service.

It is preferable that the storage medium is arranged so as to face a component mounting surface of the second board, and the connecting section is provided on the component mounting surface of the second board.

The connecting section may be provided on a side of the mounting surface of the second board, whereby it becomes possible to concentratedly mount the components on one side and produce them with ease. Moreover, it also becomes possible to bring a surface on which a component is not mounted close to, for example, a DVD player.

It is preferable that the vehicle-mounted electronic apparatus further comprising a display section and a disk player section,
wherein the storage medium is a hard disk drive,
the display section, the disk player section and the hard disk drive are arranged so as to overlap with each other, and
a sum of thicknesses of the display section, the disk player section and the hard disk drive accounts for 70% or more of a thickness of the vehicle-mounted electronic apparatus.

The boards, the components and so on are arranged in an area of 30% or less of the thickness of the electronic apparatus, whereby an electronic apparatus main body can be made thin.

It is preferable that the vehicle-mounted electronic apparatus further comprises a casing for housing the first board, the second board and the storage medium, the casing having an opening portion through which the storage medium can be attached to and detached from the casing.

The first board and the storage medium (for example, a hard disk drive) may be arranged in a row, with the result that it is possible to attach and detach the storage medium through the opening portion of the casing without being obstructed by the first board. Therefore, it becomes possible to easily carry out maintenance work such as replacement and repair of a broken unit through the opening portion of the casing.

An apparatus of related art is equipped with a plurality of functions, and comprises
a board having a voltage converting section for generating plural kinds of voltages used by respective functions,
a power IC; and
a cooling fan,
wherein the board is arranged close to the power IC and the cooling fan.

It is preferable that the voltage converting section has a regulator and a DC/DC converter.

Plural kinds of power supplies used by the respective functions are concentrated to one place and brought close to the power IC so that the components generating heat are put together, whereby the components are efficiently cooled by the cooling fan.

An apparatus of related art comprises :
a storage medium;
a disk player section; and
a board,
the storage medium, the disk player section and the board being arranged so as to overlap with each other,
wherein a height of a component mounted on the board in an area overlapping the disk player section is lower than a height of a component arranged on the board in an area not overlapping the storage medium or the disk player section.

The height of the component arranged on the board in the area overlapping the disk player section is lower than the height of the component arranged on the board in the area not overlapping the storage medium or the disk player section, and it is therefore possible to efficiently arrange the mounted components in a vacant space, downsize in the thickness direction, and provide the vehicle-mounted electronic apparatus with a number of functions.

### BRIEF DESCRIPTION OF THE DRAWINGS

Other and further objects, features, and advantages of the invention will be more explicit from the following detailed description taken with reference to the drawings wherein:
Fig. 1 is a perspective view of a vehicle-mounted electronic apparatus;
Fig. 2 is a perspective view showing the vehicle-mounted electronic apparatus, with its detachable panel unit removed;
Fig. 3 is a front view of the vehicle-mounted electronic apparatus;
Fig. 4 is a front view showing the vehicle electronic apparatus, with its detachable panel unit removed;
Fig. 5 is a bottom view of the vehicle-mounted electronic apparatus;
Fig. 6 is a perspective view showing the vehicle-mounted electronic apparatus, with its display panel unit kept in an opened state;
Fig. 7 is an exploded perspective view showing a main part of an apparatus body unit of the vehicle-mounted electronic apparatus;
Fig. 8 is an exploded perspective view showing the constituent components such as a board that are disposed in the apparatus body unit of the vehicle-mounted electronic apparatus;
Fig. 9 is an exploded perspective view showing the constituent components such as a board that are disposed in the apparatus body unit of the vehicle-mounted electronic apparatus;
Fig. 10 is a view showing arrangement in a thickness direction in the vehicle-mounted electronic apparatus;
Fig. 11 is a plan view relating to arrangement in the vehicle-mounted electronic apparatus; and
Figs. 12A and 12B are views of the vehicle-mounted electronic apparatus mounted in a vehicle, with Fig. 12A showing a state where a display panel unit of the vehicle-mounted electronic apparatus is stored in place, and Fig. 12B showing a state where the display panel unit is left opened.

### DETAILED DESCRIPTION

Now referring to the drawings, embodiments of the invention are described below.

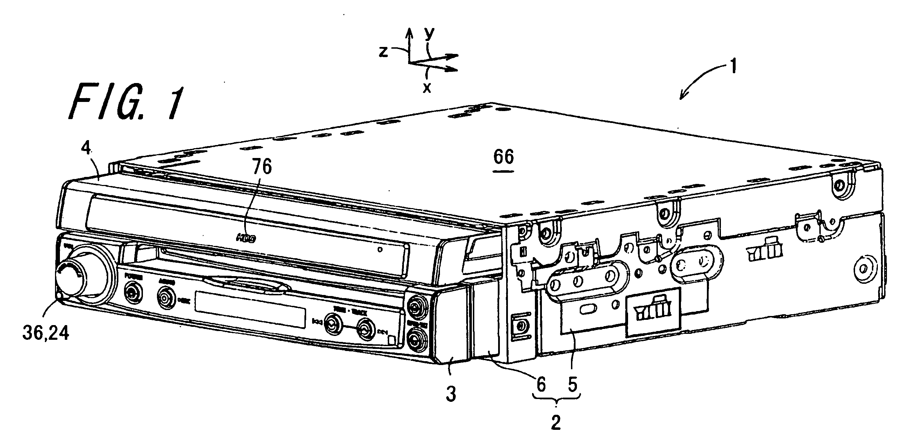

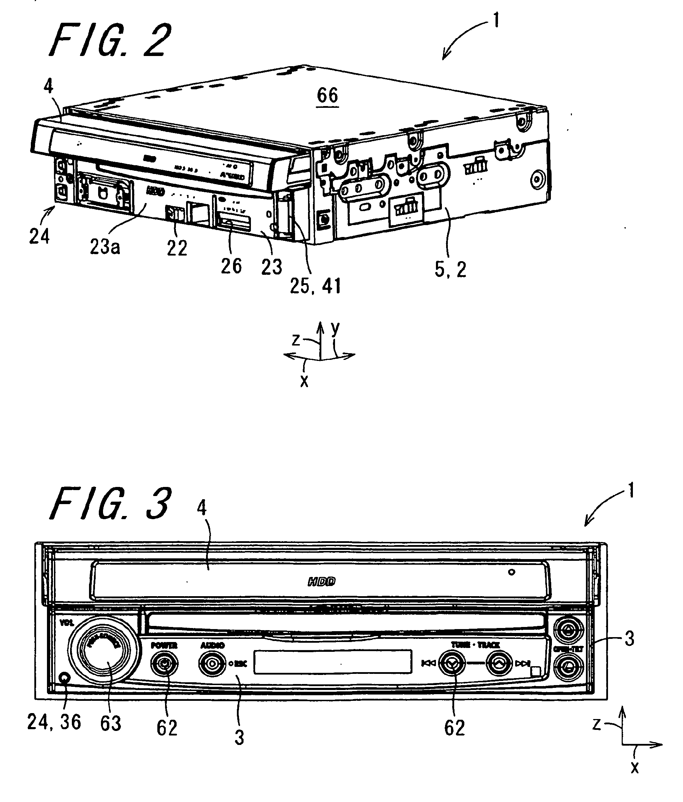

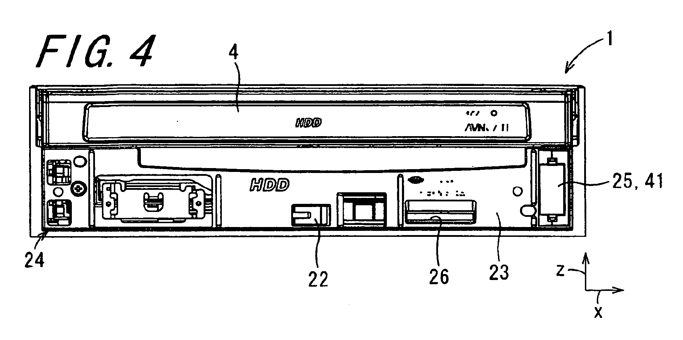

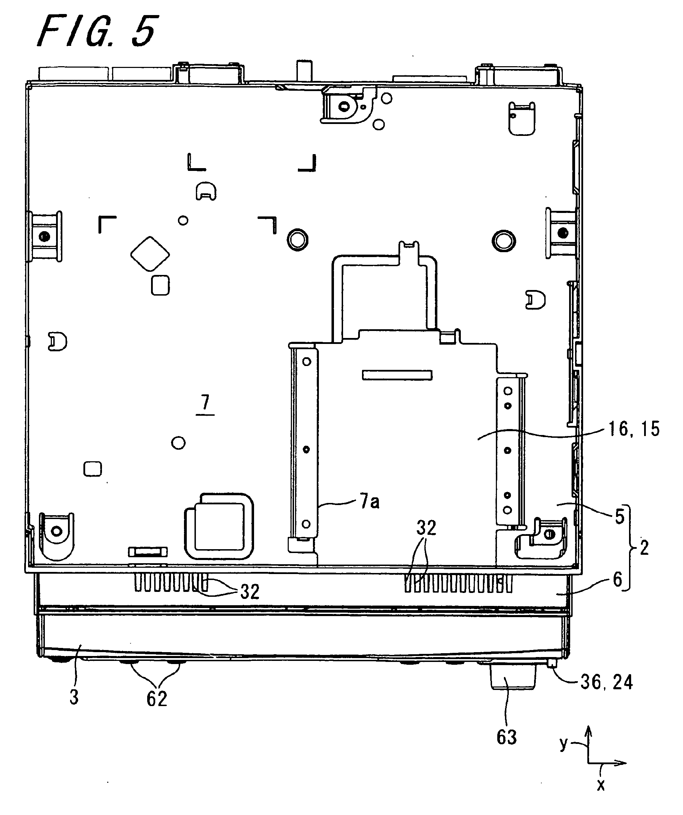

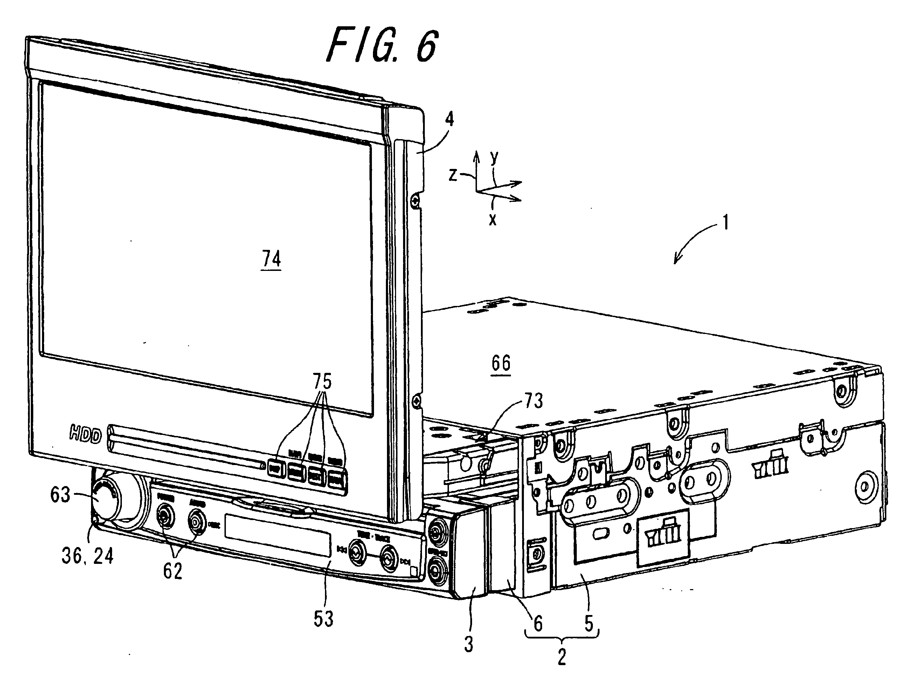

Fig. 1 is a perspective view of a vehicle-mounted electronic apparatus 1. Fig. 2 is a perspective view showing the vehicle-mounted electronic apparatus 1, with its detachable panel unit 3 removed. Fig. 3 is a front view of the vehicle-mounted electronic apparatus 1. Fig. 4 is a front view showing the vehicle-mounted electronic apparatus 1, with its detachable panel unit 3 removed. Fig. 5 is a bottom view of the vehicle-mounted electronic apparatus 1. Fig. 6 is a perspective view showing the electronic apparatus 1, with its display panel unit 4 kept in an opened state. The vehicle-mounted electronic apparatus 1 (which may be hereinafter referred to as simply an "electronic apparatus 1") concerning the embodiment is designed to be applicable to an audio visual navigation system of the 1 DIN standard. The electronic apparatus 1 is mainly composed of an electronic apparatus main body 2, the detachable panel unit 3 built as an operation section, and a display panel unit 4 serving as a display section. In the relevant figures, a direction of the depth of the electronic apparatus main body 2 is defined as a y direction, a direction of the height thereof is defined as a z direction, and a direction perpendicular to the directions y and z is defined as an x direction. The x direction, the y direction, and the z direction are each indicated by an arrow. The x direction-wise dimension, the y direction-wise dimension, and the z direction-wise dimension of the 1 DIN-sized electronic apparatus 1 concerning the embodiment are set at approximately 170 mm, 190 mm, and 47 mm, respectively. The electronic apparatus main body 2 is composed of an apparatus body unit 5 and a base panel unit 6.

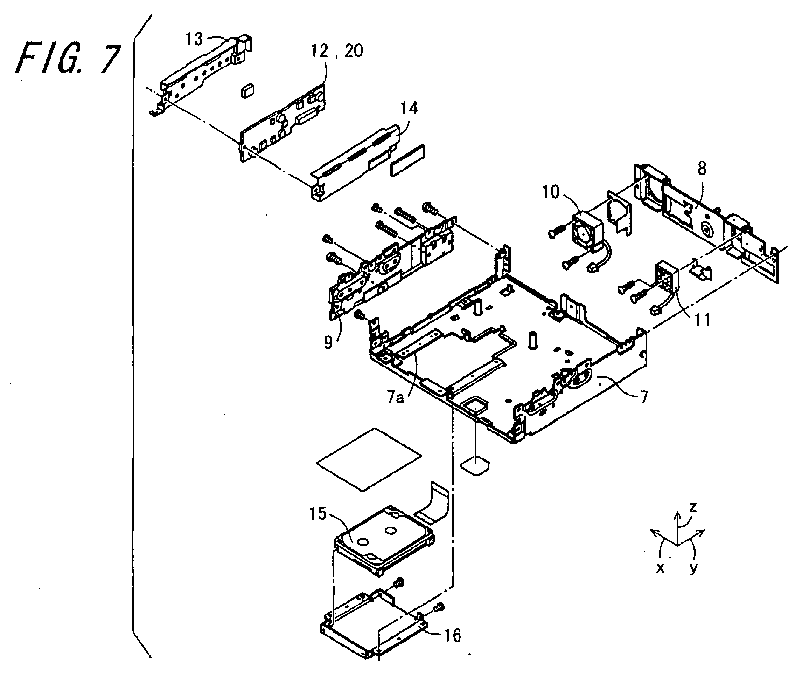

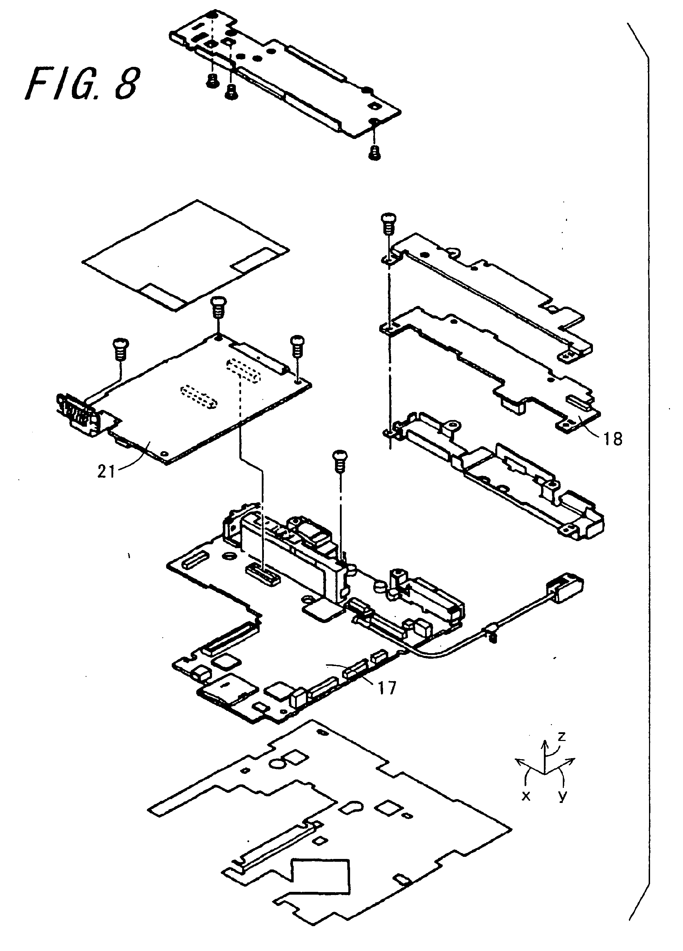

Now, the apparatus body unit 5 will be explained with reference to Figs. 7 and 8, and in addition Figs. 1 through 6 and 9. Fig. 7 is an exploded perspective view showing a main part of the apparatus body unit 5 of the electronic apparatus 1. Fig. 8 is an exploded perspective view showing the constituent components such as a board that are disposed in the apparatus body unit 5 of the electronic apparatus 1. As shown in Fig. 7, the apparatus body unit 5 is composed of a main chassis 7 serving as a casing, a rear chassis 8, a heat sink 9 built as a heat dissipating plate, a first and a second fan 10 and 11, a DC/DC converter 12, a pair of holders 13 and 14 for holding the DC/DC converter 12 (herein referred to as a "DC/DC converter holder"), a hard disk drive 15 (HDD for short) serving as a storage medium, and a holder 16 for holding the hard disk drive 15 (herein referred to as a "HDD holder 16"). The main chassis 7 constitutes a main body unit. Moreover, as shown in Fig. 8, the apparatus body unit 5 is further provided with a navigation board 17 serving as a first board, a pre-out board 18,an MCM board (multi chip module board) 21 serving as a second board, a DC/DC converter board 20, and shielding plates of various type.

With respect to the main chassis 7, at one side edge in the x direction thereof, the heat sink 9 is provided in an upright manner so as to lie in a y-z plane, and at one side edge in the y direction thereof, the rear chassis 8 is provided in an upright manner so as to lie in an x-z plane. One end in the x direction of the rear chassis 8 is equipped with the first fan 10 for cooling mainly the MCM board 21 and the DC/DC converter board 20 by exhausting cool air, and the other end in the x direction of the rear chassis 8 is equipped with the second fan 11 for cooling mainly the navigation board 17 by exhausting cool air. The first and second fans 10 and 11 will occasionally be referred to as a "double fan". In this embodiment, the double fan is arranged face to face with the HDD 15, a CPU (Central Processing Unit), and a power amplifier, each of which generates a larger amount of heat. This arrangement helps enhance the effect of heat dissipation. Moreover, considering that the CPU is the origin of digital noise in a non-illustrated digital circuitry section, by spacing apart the CPU and a tuner as will be mentioned later on, it is possible to minimize the influence of noise.

In the main chassis 7, the DC/DC converter 12 received by the DC/DC converter holder 13, 14 is retained at one end in the x direction thereof in the vicinity of the heat sink 9. As shown in Figs. 5 and 7, the main chassis 7 is provided with a hole 7a that is an opening portion for housing the HDD 15. Through the hole 7a, the HDD 15, the recorded data of which may vary from destination to destination, and the HDD holder 16 are inserted so that they can be housed in the bottom portion of the electronic apparatus 1. In order to serve the purposes of, for example, coping with the crash of an HDD, allowing replacement of an existing HDD before it approaches the end of its life cycle, and exchanging a HDD for the one of higher storage capacity, the HDD 15 and the HDD holder 16 are designed to be exchangeable through the hole 7a.

The MCM board 21 is disposed as if to occupy one area in the x direction of the main chassis 7. The MCM board 21 is constructed of a DSP (Digital Signal Processor) board in combination with, for example, a music juke for automatically recording music data on the HDD 15. In contrast to a conventional construction in which a DSP board and a music juke are provided independently of each other, the use of such an MCM board 21 makes it possible to achieve miniaturization of the electronic apparatus 1, to reduce the number of constituent components, and to effect takt time saving. Moreover, the navigation board 17 is disposed as if to occupy most part of the other area in the x direction and a part of one area in the x direction on the main chassis 7.

The pre-out board 18 is also referred to as a "sub board 18". The specification of the sub board 18, for example, the presence or absence of a tuner, is determined in accordance with the place of destination. The sub board 18 is disposed along one side edge in the z direction of the rear chassis 8. The sub board 18, the rear chassis 8, the main chassis 7, the heat sink 9, and others constitute a substantially air-tightly sealed space. Moreover, while the time the display panel unit 4 is in an opened state, the MCM board 21 and the navigation board 17 have their one sides in the z direction exposed. This allows air to flow from the MCM board 21 and the DC/DC converter board 20 to the first fan 10, as well as from the navigation board 17 to the second fan 11, in an efficient manner. In other words, the MCM board 21 and the DC/DC converter board 20 are located in one area in the x direction of the main chassis 7 so as to face the first fan 10, whereas the navigation board 17 is located in the other area in the x direction of the main chassis 7 so as to face the second fan 11. With this arrangement, the MCM board 21, the DC/DC converter board 20, and the navigation board 17 can be cooled individually by the cool-air exhausting action of the fan, wherefore the heat-generating constituent components undergo cooling in an efficient manner.

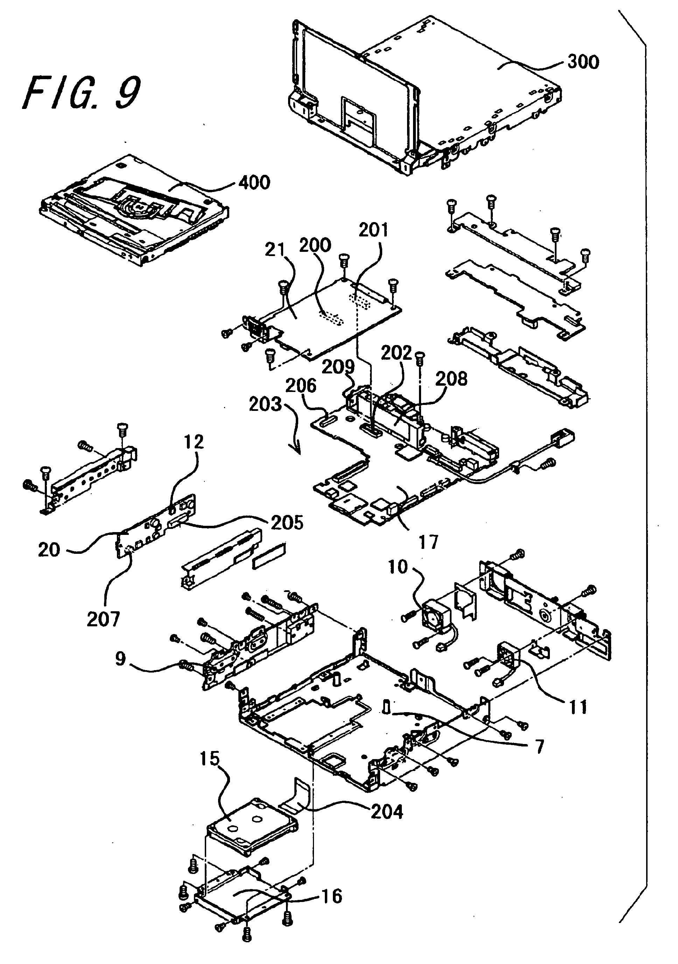

Fig. 9 is a view for describing the invention. In the navigation board 17 as the first board, a cutout portion 203 for avoiding interference with the hard disk drive 15 is formed. That is to say, on the main chassis 7, the navigation board 17 does not overlap the hard disk drive 15 in the thickness direction. Consequently, it is possible to downsize in the thickness direction. The MCM board 21 as the second board is disposed over the hard disk drive 15, and connected with the hard disk drive 15 via a flexible wire 204 and a connector 200 which serve as connecting sections. Therefore, the hard disk drive 15 is connected to the MCM board 21 disposed just thereon, and a distance therebetween is very short. Since the distance is short, it is possible to prevent that decrease of a communication speed is caused, and it is also possible to reduce noise received at the time of communication. Moreover, the MCM board 21 arranged on the hard disk drive 15 is arranged so that a board surface of the MCM board and a board surface of the navigation board 17 face each other. In the facing part, the MCM board and the navigation board have connectors 201 and 202, respectively, and are electrically connected. That is to say, the navigation board 17 as the first board and the MCM board 21 as the second board are arranged so as to surround the hard disk drive 15, and the navigation board 17 faces the MCM board 21. Therefore, it is possible to easily connect by the connectors or the like without using a long wire.

Although the navigation board 17 has the cutout portion 203 in the present embodiment, the navigation board may have a hole-shaped portion instead. Moreover, although the hard disk drive 15 is arranged under the MCM board 21 in the present embodiment, the hard disk drive 15 may be arranged over the board instead.

Furthermore, the components to be mounted on the MCM board 21 are mounted on one surface of the MCM board, and the mounting surface is made to face the hard disk drive 15, whereby it is possible to make a flatter surface on the opposite side to the mounting surface of the MCM board 21 face a DVD player, and it is also possible to arrange the MCM board 21 closer to the DVD player.

Further, it is possible to take out the hard disk drive 15 by detaching the HDD holder 16 attached into in the hole 7a of the main chassis 7, and it is possible to detach only the hard disk drive 15 by detaching the connector 200 of the MCM board 21 joined to the flexible wire 204. Since the navigation board 17 is not interposed between the hard disk drive 15 and the main chassis 7, it is possible to easily attach and detach the hard disk drive 15 through the hole 7a of the main chassis. Next, arrangement of the DC/DC converter board 20 will be described. Together with a display section 300 and a DVD player 400, the navigation board 17 and the MCM board 21 are arranged in a horizontal direction so as to be stacked. On the other hand, the DC/DC converter board 20 is arranged in a vertical direction, and connected to a connector 206 of the navigation board 17 by a connector 205.

The DC/DC converter board 20 is provided with, in addition to the DC/DC converter 12, a regulator 207 for supplying a plurality of different values of voltages to a navigationportion, a disk player section, a microcomputer and so on, thereby supplying voltages of, for example, 10V, 9V, 8V, 5V, 3.3V, 2.5V and 1. 25V. In the present embodiment, the DC/DC converter board 20 generates all the voltages used by the various kinds of functions. The DC/DC converter board 20 generates heat when converting voltages. Another component that generates heat is a power IC 209 disposed on the navigation board 17. The components that generate heat are put together in one place (in the vicinity of a left side face of the casing) in the main body, and the cooling fan 10 is disposed behind the components, whereby the components are efficiently cooled. Since the cooling fan 10 rotates so as to exhaust inside hot air, arrangement of the DC/DC converter board 20 and the power IC 209 in a line along an exhausting direction enables the cooling fan to further efficiently cool. Moreover, in order to enhance a cooling effect in this part, a cooling fan larger in size than the cooling fan 11 is adopted as the cooling fan 10, whereby a cooling capability is increased. The cooling fan 10 cools chiefly heat generated by the power source system, and the cooling fan 11 cools a part away from the cooling fan 10, whereby a proper cooling effect is obtained throughout in the casing. The numbers of rotations of the cooling fan 10 and the cooling fan 11 may be the same, or may be differentiated on purpose.

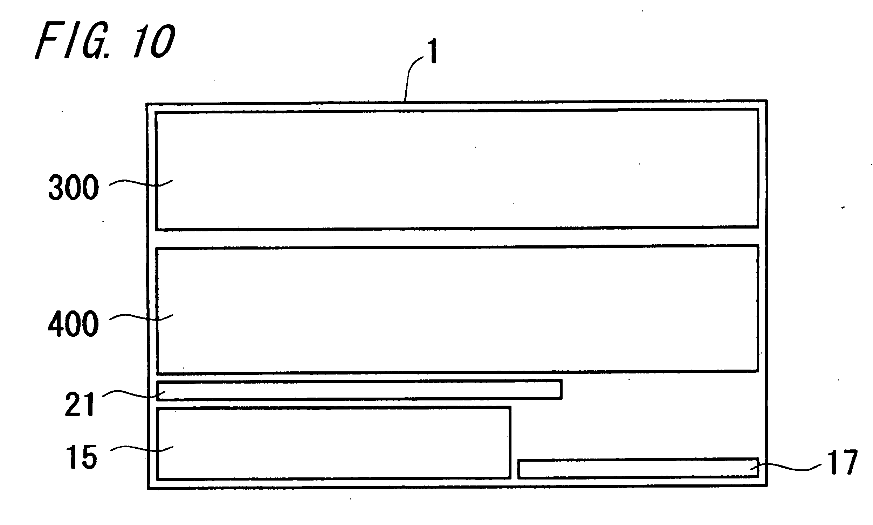

As illustrated in Fig. 10, in the vehicle-mounted electronic apparatus of the invention, the following elements are arranged in a direction of a thickness of 1DIN size: the display section 300 serving as a display section having a thickness of 15 mm, which accounts for 32% of the thickness of 1DIN size; the DVD player section 400 serving as a reproducing section having a thickness of 16 mm, which accounts for 34%; and the hard disk drive portion 15 serving as a storage medium having a thickness of 5 mm, which accounts for 10%. Accordingly, a sum of the thicknesses of the above portions accounts for approximately 76% of the thickness of 1DIN size. Since the boards and so on must be arranged within the remaining thickness that accounts for approximately 24%, how to arrange the boards and the mounted components is important.

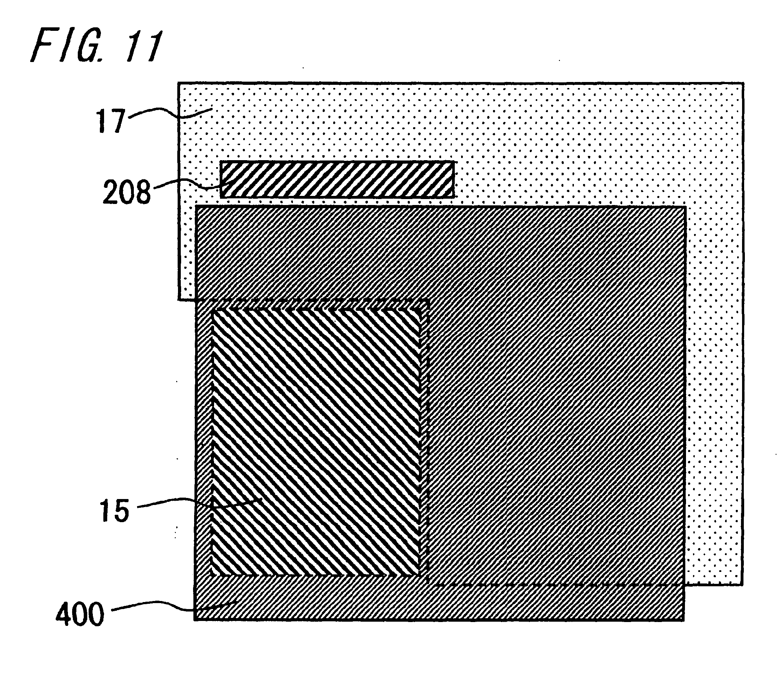

As illustrated in Fig. 11 in specific, the DVD player section 400 covers most part of the navigation board 17. Moreover, since the MCM board 21 and so on are arranged on the hard disk drive 15, it is difficult to make the electronic apparatus thin unless the height of the component mounted on the navigation board 17 is low. Therefore, a tall component such as a radio tuner module 208 is arranged on the navigation board 17 outside an area of the DVD player section 400, and a relatively small and short component is arranged on the board in an area overlapping the DVD player section 400. Consequently, it becomes possible to efficiently use a vacant space, so that it is possible to house the respective portions in the electronic apparatus main body in a highly dense state.

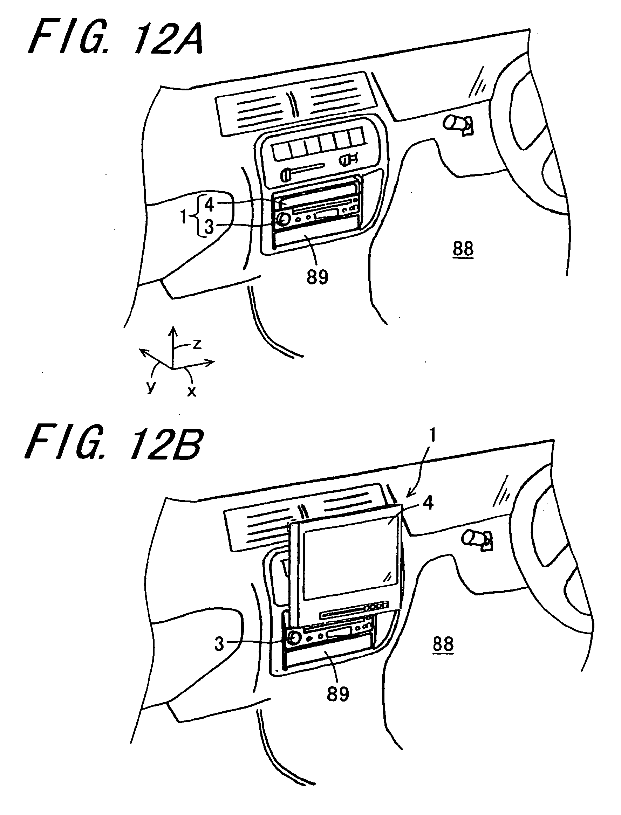

Figs. 12A and 12B are views of the vehicle-mounted electronic apparatus 1 mounted in a vehicle 88, with Fig. 12A showing a state where the display panel unit 4 is stored in place, and Fig. 12B showing a state where the display panel unit 4 is left opened. In an instrument panel of the vehicle 88 is normally secured a space for a vehicle-mounted audio system or the like apparatus. For example, an electronic apparatus, a glove compartment, or a cup holder can be emplaced in the space at user's choice. In order to enhance the mountability of such instruments, the space is created in conformity with certain dimensional standards. For example, the DIN standards have been widely adopted for defining a length/width dimension of the space.

The space created in the instrument panel of the vehicle 88 is generally set at 2 DIN or 1 DIN in size. In accordance with the size of the space, any given apparatus is mounted therein at user's choice. For example, a 2 DIN space allows the placement of a single electronic apparatus of 2 DIN size, two pieces of electronic apparatuses of 1 DIN size, or a combination of a single electronic apparatus of 1 DIN size and a glove compartment of 1 DIN size.

The example shown in Figs. 12A and 12B is associated with the case where a 2 DIN space is provided, in the upper part of which is disposed the electronic apparatus 1 of 1 DIN size concerning the embodiment, whereas in the lower part of which is disposed a glove compartment 89 of 1 DIN size. The display panel unit 4 is, when actuated, opened upwardly of the space so that an apparatus (although the glove compartment is mounted in this example, an electronic apparatus such as a radio can also be mounted) disposed in the lower part of the 2 DIN space can be operated without any hindrance.

As described heretofore, by designing the electronic apparatus in conformity with the 1 DIN standard, it is possible to make good use of the space, and thereby enable the addition of another apparatus. Moreover, even if there is only a 1 DIN space, the electronic apparatus can be disposed therein, wherefore the convenience of users can be improved.

## Claims

1. A vehicle-mounted electronic apparatus (1) comprising:
a display section (4, 300) for displaying information thereon;
a reproducing section (400) for reproducing information recorded in a recording medium to be inserted;
a main body unit having an opening portion (7a), and
a storage medium (15) containing information recorded therein,
wherein
said storage medium (15) is a hard disc drive; and **characterized in that**
the main body unit (7) houses the display section (4, 300), the reproducing section (400), and the storage medium (15) which are stacked in this order,
wherein through said opening portion (7a) of the main body unit the storage medium can be attached to and detached from the main body unit.

2. The apparatus of claim 1, further comprising:
a first board (17) in which an avoiding portion for avoiding interference with the storage medium(15) is formed;
a second board (21) arranged on the storage medium (15); and
a connecting section that connects the storage medium (15) with the second board (21).

3. The apparatus of claim 2, wherein the reproducing section (400) and the second board (21) are arranged so that the reproducing section (400) and at least a part of the second board (21) overlap with each other, and
a height of a component arranged on the second board (21) in an area overlapping the reproducing section (400) is lower than a height of a component arranged on the second board (21) in an area not overlapping the reproducing section (400).

## Patentansprüche

1. Elektronisches Gerät (1) zum Einbau in einem Fahrzeug,
das aufweist:
einen Anzeigeabschnitt (4, 300) zur Anzeige von Informationen darauf,
einen Wiedergabeabschnitt (400) zur Wiedergabe von Informationen, die in einem einzusetzenden Aufzeichnungsmedium aufgezeichnet sind,
eine Hauptgehäuseeinheit mit einem offenen Bereich (7a) und
ein Speichermedium (15), das darin aufgezeichnete Informationen enthält, wobei das Speichermedium (15) ein Festplattenlaufwerk ist,
**dadurch gekennzeichnet, dass**
in der Hauptgehäuseeinheit (7) der Anzeigeabschnitt (4, 300), der Wiedergabeabschnitt (400) und das Speichermedium (15) vorgesehen sind, die in dieser Reihenfolge übereinander angeordnet sind,
wobei das Speichermedium durch den offenen Bereich (7a) der Hauptgehäuseeinheit an der Hauptgehäuseeinheit angebracht und von ihr entfernt werden kann.

2. Gerät nach Anspruch 1, das ferner aufweist:
eine erste Platine (17), in der ein Ausnehmungsbereich zur Vermeidung von Störungen des Speichermediums (15) ausgebildet ist,
eine zweite Platine (21), die auf dem Speichermedium (15) angeordnet ist,
und
einen Verbindungsabschnitt, der das Speichermedium (15) mit der zweiten Platine (21) verbindet.

3. Gerät nach Anspruch 2, bei dem der Wiedergabeabschnitt (400) und die zweite Platine (21) so angeordnet sind, dass der Wiedergabeabschnitt (400) und zumindest ein Teil der zweiten Platine (21) einander überlappen,
und
die Höhe einer Komponente, die auf der zweiten Platine (21) in einem Bereich angeordnet ist, der den Wiedergabeabschnitt (400) überlappt, kleiner ist als die Höhe einer Komponente, die auf der zweiten Platine (21) in einem Bereich angeordnet ist, der den Wiedergabeabschnitt (400) nicht überlappt.

## Revendications

1. Appareil électronique embarqué à bord d'un véhicule (1) comprenant :
une section d'affichage (4, 300) permettant d'afficher des informations sur celle-ci ;
une section de reproduction (400) permettant de reproduire des informations enregistrées sur un support d'enregistrement à insérer ;
une unité de corps principal possédant une partie d'ouverture (7a), et
un support de stockage (15) contenant des informations enregistrées dessus,
dans lequel
ledit support de stockage (15) est un lecteur de disque dur ;
**caractérisé en ce que**
l'unité de corps principal (7) contient la section d'affichage (4, 300), la section de reproduction (400) et le support de stockage (15) qui sont empilés dans cet ordre,
dans lequel le support de stockage peut être fixé sur l'unité de corps principal et détaché de celle-ci par l'intermédiaire de ladite partie d'ouverture (7a) de l'unité de corps principal.

2. L'appareil de la revendication 1, comprenant en outre :
une première carte (17) dans laquelle est formée une partie d'évitement permettant d'éviter les interférences avec le support de stockage (15) ;
une seconde carte (21) disposée sur le support de stockage (15) ; et
une section de connexion qui relie le support de stockage (15) à la seconde carte (21).

3. L'appareil de la revendication 2, dans lequel la section de reproduction (400) et la seconde carte (21) sont disposées de telle sorte que la section de reproduction (400) et au moins une partie de la seconde carte (21) se chevauchent l'une l'autre, et
une hauteur d'un composant disposé sur la seconde carte (21) dans une zone chevauchant la section de reproduction (400) présente une dimension inférieure à une hauteur d'un composant disposé sur la seconde carte (21) dans une zone ne chevauchant pas la section de reproduction (400).
